(19) Europäisches Patentamt
European Patent Office
Office européen des brevets

(11) **EP 2 475 223 A1**

(12) **EUROPEAN PATENT APPLICATION**
published in accordance with Art. 153(4) EPC

(43) Date of publication:
**11.07.2012 Bulletin 2012/28**

(21) Application number: **10813763.9**

(22) Date of filing: **02.09.2010**

(51) Int Cl.:
*H05B 33/04* (2006.01)  *B32B 15/08* (2006.01)
*B32B 15/092* (2006.01)  *C08G 59/68* (2006.01)
*H01L 51/50* (2006.01)

(86) International application number:
**PCT/JP2010/065010**

(87) International publication number:
**WO 2011/027815 (10.03.2011 Gazette 2011/10)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **04.09.2009 JP 2009204259**

(71) Applicant: **Threebond Co., Ltd.**
**Hachioji-shi, Tokyo 193-8533 (JP)**

(72) Inventors:
• **ARAI, Yoshihide**
**Hachioji-shi**
**Tokyo 193-8533 (JP)**

• **KITAZAWA, Hiromasa**
**Hachioji-shi**
**Tokyo 193-8533 (JP)**
• **HORIE, Kenichi**
**Hachioji-shi**
**Tokyo 193-8533 (JP)**

(74) Representative: **Gendron, Vincent Christian et al**
**SA FEDIT-LORIOT ET AUTRES**
**38, avenue Hoche**
**75008 Paris (FR)**

(54) **ORGANIC EL ELEMENT SEALING MEMBER**

(57) The present invention provides a sealing member for organic EL elements that enables organic EL elements, in particular, organic EL elements for illumination devices to maintain stable luminescence over a long period and that can be fabricated at reduced cost. The sealing member for organic EL elements of the present invention includes a barrier film including a plastic film and at least one thin metal layer, and a curable resin composition layer on the barrier film. The curable resin composition layer has a thickness of 5 to 100 $\mu$m and the curable resin composition exhibits nonfluidity at 25°C in an uncured state and gains fluidity at an elevated temperature in the range of 40 to 80°C.

EP 2 475 223 A1

**Description**

Technical Field

The present invention relates to a sealing member for organic electroluminescence (EL) elements that can emit light at high luminance under an applied electric field. More specifically, the present invention relates to a sealing member for organic EL elements, the sealing member including a curable resin composition layer and being used to cover entire surfaces of organic EL elements to protect the organic EL elements from, for example, moisture, and oxygen.

Background Art

Organic EL elements, which are polycrystalline semiconductor devices and can emit high-luminance light at a low voltage, are used, for example, as backlights of liquid crystal displays. The organic EL devices, which are thin and light, are also expected to be used, for instance, for thin flat displays such as flat-panel television sets. The organic EL elements, however, are significantly susceptible to moisture and oxygen. Consequently, they may undergo interfacial separation between metal electrodes and organic EL layers, increased resistivity of metal electrodes due to oxidation, and degradation of organic substances. These factors lead to drawbacks of organic EL elements, for example, failure of light emission and reduced brightness even with light emission. Meanwhile, in order to reduce the thickness of a device including an organic EL element, a possible measure is thinning of a substrate used for a sealing member to seal the organic EL element. For example, a plastic film having barrier characteristics can be used in place of a glass or metal substrate. Unfortunately, such a plastic film does not provide a sufficient barrier effect. Furthermore, its sealing process by bonding the plastic film to the substrate for the organic EL element is unsatisfactory.

Various methods have been proposed to solve these problems, for example, a method of molding an organic EL element with acrylic resin (Patent Literature 1), a method of shielding an organic EL element from the atmosphere by placing the organic EL element in a hermetic case filled with phosphorus pentoxide (Patent Literature 2), a method of hermetically shielding an organic EL element that involves providing a sealing layer consisting of metal oxide, metal fluoride, or metal sulfide on an opposite surface, remote from a substrate, of an organic EL element, by bonding an airtight plate such as a glass plate or foil to the opposite surface, or by combining these ways (Patent Literature 3), a method of sealing an organic EL element that involves providing a protective layer composed of an insulating polymer compound on the outer surface of an organic EL element and providing a shield layer composed of one selected from the group consisting of glass, polymer, and hermetic fluid having electrical insulating properties on the outer side of the protective layer (Patent Literature 4), a method of enhancing the life of an organic EL element that involves placing the organic EL element in an inert liquid compound consisting of fluorinated carbon to minimize the Joule heat produced by an electrical current between electrodes (Patent Literature 5), a method of sealing an organic EL element that involves providing a protective layer composed of an insulating inorganic compound on the outer surface of the organic EL element and providing a shield layer composed of one selected from the group consisting of glass, polymer, and hermetic fluid having electrical insulating properties on the outer side of the protective layer (Patent Literature 6), and a method of achieving high durability of an organic EL element that involves confining the organic EL element in an inert substance, preferably, silicone oil or liquid paraffin (Patent Literature 7). Moreover, a method for protecting an organic EL element from moisture is recently proposed, which involves laminating a sealing resin containing a desiccant on the organic EL element (Patent Literature 10). Besides these methods, proposed is providing a moisture-proof photocurable epoxy layer containing a desiccant such as barium oxide or calcium oxide, in addition to a sealing layer, in order to eliminate adverse effects of moisture to an organic EL element (Patent Literature 11).

Unfortunately, all of the above proposed methods of sealing organic EL elements are unsatisfactory. For example, formation and propagation of dark spots cannot be prevented by sealing an organic EL element and a desiccant in a hermetic structure. The method of storing an organic EL element in fluorinated carbon or silicone oil makes a sealing process complicated since it requires a step of charging a liquid, cannot completely prevent increased dark spots, and even accelerates undesirable separation of a cathode by the liquid penetrating to the interface between the cathode and an organic EL layer. The method of adding a desiccant to a sealing resin makes handling thereof cumbersome due to moisture absorption of the resin prior to a sealing procedure, and thus leads to separation caused by hygroscopic expansion of the resin.

Methods are proposed which involve sealing an organic EL element using a resin film dry-laminated with metal foil (Patent Literatures 8 and 9). A sufficient adhesion is however not achieved by these methods for the reasons that curable resins used for bonding are thermoplastic resins such as common copolymer of ethylene and vinyl acetate, and that the thermoplastic resins do not have sufficient wettability to substrates due to, for instance, a high bonding temperature of 150°C. Moreover, a composition containing such curable resins cannot follow the asperity of an organic EL element, resulting in trapping of air bubbles, and formation of dark spots.

One of the sealing agents used for direct sealing of IC or LSI chips is a paste composition composed of a thermoplastic resin, an epoxy resin, a coupling agent, silica powder, and an organic solvent (Patent Literature 12). The invention focuses on stress relaxation (resilience) of a cured substance. The patent literature discloses that the paste composition exhibits high resistance to moisture, but does not disclose the amount of the moisture contained in the paste composition. Furthermore, the use of two-component curable liquid epoxy resin requires an additional facility for compounding and mixing. Another disadvantage is low workability due to a time-consuming operation and a limited pot life.

Patent Literature 13 discloses a resin composition containing a curing agent composed of a reaction product of a styrene-maleic anhydride copolymer and primary and secondary amines. The resin composition is applied to a surface of a substrate and is cured by heat for use as a transparent protective film. Unfortunately, the composition, which contains styrene, is not suitable for sealing organic EL elements. Patent Literatures 14 and 15 disclose an epoxy resin sealant composition in which an acid anhydride curing agent is used with imidazole as a curing accelerator. The composition cannot be used for sealing organic EL elements because the composition has high curing temperature that causes the organic EL elements to be damaged.

Patent Literatures 16 and 17 disclose an adhesive film or a thermosetting resin that contains imidazole as a curing agent or a curing accelerator. These materials have high curing temperature that damages organic EL elements and thus cannot be used for sealing organic EL elements. Patent Literature 18 discloses an adhesive composition containing a liquid imidazole compound. Unfortunately, the composition does not have thermal stability during shaping into a sheet. Moreover, Patent Literature 19 discloses an epoxy resin composition containing an epoxy resin, a phenoxy resin, and a curing agent in a predetermined proportion. The literature does not mention flow temperature, moisture content, and amount of outgas produced, and the composition is not suitable for sealing an entire surface of an organic EL element.

A major problem of sealing with a liquid resin is generation of air bubbles during a bonding process of an organic EL element to a sealing substrate. It is extremely difficult to bond together without trapping air bubbles on the entire surface of a display, and the trapped air bubbles reduces the life of the element. In addition, in the case where a liquid resin is used to bond an organic EL element to a sealing substrate during a process of cutting a mother substrate, masking is required for portions at which the organic substrate and the sealing substrate are not bonded, resulting in low workability.

Patent Literature 20 discloses a method of sealing that involves applying a photocurable sealant on spots equally spaced over the entire adherend surface and then curing with alignment and gap adjustment. This method has disadvantages of difficulty in control of uniformity of the thickness of adherend and unavoidable trapping of air bubbles. Since the photocurable sealant has low viscosity suitable for spot application, a dam material having high viscosity should be provided at the peripheries of a substrate to prevent the photocurable sealant from spreading out during a bonding process. The low-viscosity sealant also has adverse effects such as generation of dark spots.

Patent Literature 21 discloses a photosensitive composition composed of an epoxy compound having at least two epoxy groups, a predetermined polynuclear phenolic compound, and a radiation-sensitive cationic polymerization initiator. Its sealing structure however is a conventional hollow structure; thus its reliability cannot be secured without a desiccant. Moreover, the hollow structure inevitably involves optical loss. Patent Literature 22 discloses a sealing member for an organic EL element, the sealing member being composed of a flexible polymer composition and disposed between a light-emitting surface of a light-emitting element and a sealing element. Since the sealing member is merely disposed without adhesion, high reliability of the element cannot be ensured. Patent Literature 23 discloses an organic EL element composed of a rear substrate; an organic EL diode including a first electrode, an organic film, and a second electrode; and an encapsulation layer composed of a nanocomposite containing a laminar inorganic substance, a polymer, and a curing agent and encapsulated in an internal space that is defined with the rear substrate and accommodates the organic EL diode. The encapsulation layer, composed of the nanocomposite formed of the laminar inorganic substance, polymer, and curing agent, fills in the internal space and functions as a desiccant. This layer ensures reliability to a coating-type desiccant, not a conventional adhesive desiccant. Consequently, the encapsulation layer does not have a function to bond the upper and lower substrates. Accordingly, a sealant or filler is required to fill a gap between the upper and lower substrates, in addition to the encapsulation layer.

Recently, for instance, as disclosed in Patent Literature 24, use of organic EL elements for illumination has been discussed. A conventional organic EL element for illumination has a hollow structure formed of a glass or metal, which precludes a reduction in thickness of a device and an enhancement in impact resistance. A further disadvantage is nonuniformity of the luminance and durability for instance, caused by heat produced during light emission. Consequently, organic EL elements for illumination devices require, for example, durability in various operational environments, applicability to any component, and productivity for mass production.

A barrier film has a great potential as a sealing material for organic EL elements used in illumination devices. In the invention of Patent Literature 25, a two-component curable epoxy resin is used as a curable resin composition constituting the barrier film (Patent Literature 25). Unfortunately, such a two-component curable epoxy resin should be weighed and mixed just before it is applied, and its pot life is limited. Moreover, the liquid materials have their inherent various problems, such as difficulty in formation of a uniform curable resin composition over a substrate having a large surface and a time-consuming operation to move a nozzle of a dispensing robot to target positions in a coating process of the curable resin composition, which problems preclude continuous production.

To solve these problems, Patent Literature 26 proposes a sealing member for organic EL elements that has a structure in which a curable resin composition is disposed on a film constituting a substrate in advance, suitable for production by a roll-to-roll process. In this literature, the roll-to-roll process still has low productivity because the curable resin composition is applied onto a film such as a PET film having a relatively large thickness. Moreover, an inorganic film layer is sandwiched between two curable resin composition layers composed of an epoxy resin, which structure is not practical for the reason that cumbersome processes are required for its production.

Citation List

Patent Literatures

Patent Literature 1:
Japanese Patent Application Laid-Open H3-37991
Patent Literature 2:
Japanese Patent Application Laid-Open H 3-261091
Patent Literature 3:
Japanese Patent Application Laid-Open H 4-212284
Patent Literature 4:
Japanese Patent Application Laid-Open H 5-36475
Patent Literature 5:
Japanese Patent Application Laid-Open H 4-363890
Patent Literature 6:
Japanese Patent Application Laid-Open H 5-89959
Patent Literature 7:
Japanese Patent Application Laid-Open H 5-129080
Patent Literature 8:
Japanese Patent Application Laid-Open 2001-237065
Patent Literature 9:
Japanese Patent Application Laid-Open 2007-109422
Patent Literature 10:
Japanese Patent Application Laid-Open 2007-284475
Patent Literature 11:
Japanese Patent Application Laid-Open 2001-237064
Patent Literature 12:
Japanese Patent Application Laid-Open H 11-274377
Patent Literature 13:
Japanese Patent Application Laid-Open H 9-176413
Patent Literature 14:
Japanese Patent Application Laid-Open H 9-235357
Patent Literature 15:
Japanese Patent Application Laid-Open H 10-135255
Patent Literature 16:
Japanese Patent Application Laid-Open 2004-59718
Patent Literature 17:
Japanese Patent Application Laid-Open 2004-210901
Patent Literature 18:
Japanese Patent Application Laid-Open 2004-115650
Patent Literature 19:
Japanese Patent Application Laid-Open 2004-292594
Patent Literature 20:
Japanese Patent Application Laid-Open 2008-59945
Patent Literature 21:
WO2005/019299
Patent Literature 22:

Japanese Patent Application Laid-Open 2005-129520
Patent Literature 23:
Japanese Patent Application Laid-Open 2005-216856
Patent Literature 24:
Japanese Patent Application Laid-Open 2004-234868
Patent Literature 25: 1
Japanese Patent Application Laid-Open 2004-47381
Patent Literature 26:
WO2006/104078

Summary of the Invention

Technical Problem

As described above, the insufficient solution to degradation due to dark spots and unstable luminescence of organic EL elements are severe drawbacks as light sources such as backlights for facsimiles, copying machines, and liquid crystal displays, and are unsuitable for display devices such as illumination devices and flat-panel displays. Since organic EL elements for illumination must be produced by continuous production processes at reduced cost with high reliability, improved productivity is a particularly important factor and a technique for achieving such a need has been awaited. The present invention solves the problems in the above conventional art. The present invention provides a sealing member that can seal organic EL elements without adverse effects such as formation or propagation of dark spots, enables organic EL elements to maintain stable luminescence over a long period, and can be produced at high productivity contributing to low-cost production of organic EL elements.

Solution to Problems

In order to solve the above problems, the present inventors have created a sealing member for an organic EL element having the following structure. That is, the present invention provides a sealing member for an organic EL element comprising a barrier film including a plastic film and at least one, preferably one to five, more preferably one to three thin metal layers; and a curable resin composition layer on the barrier film, the curable resin composition layer having a thickness of 5 to 100 $\mu$m, the curable resin composition having nonfluidity at 25°C in an uncured state and gaining fluidity at an elevated temperature in the range of 40 to 80°C.
In a preferred embodiment of the sealing member for an organic EL element, the thin metal layer comprises at least one metal selected from the group consisting of aluminum, magnesium, zinc, copper, gold, silver, platinum, tungsten, manganese, titanium, cobalt, nickel, and chromium; and the plastic film comprises at least one resin selected from the group consisting of polyethylene terephthalate, polyvinyl alcohol, polyethylene naphthalate, polyamide, polyolefin, polycarbonate, polyether sulfone, and polyarylate. Lamination of the thin metal layer and the plastic film can produce a lightweight barrier layer having low permeability to oxygen and moisture. The sealing member for an organic EL element thus can be applied to flexible organic EL elements suitable for illumination devices and image display devices for mobile phones and television sets for instance, in particular illumination devices. In more preferred embodiment of the sealing member for an organic EL element, the plastic film has a thickness of 1 to 50 $\mu$m, and the thin metal layer has a thickness of 1 to 50 $\mu$m.
In a particularly preferred embodiment of the sealing member for an organic EL element, the curable resin composition layer comprises a curable resin composition comprising:

(A) a compound containing at least one glycidyl group per molecule and having a weight average molecular weight of 200 to 2,000;
(B) a phenoxy resin containing at least one glycidyl group per molecule and having a weight average molecular weight of 20,000 to 100,000, wherein the amount of the component (B) is preferably 25 parts to 100 parts by mass, relative to 100 parts by mass of the component (A);
(C) (c-1) a compound generating an acid by exposure to active energy radiation, and/or (c-2) a thermal latent curing agent, wherein the amount of the component (c-1) is preferably 0.1 part to 5.0 parts by mass and/or the amount of the component (c-2) is preferably 0.1 part to 20 parts by mass, relative to 100 parts by mass of the total amount of the component (A) and the component (B); and
(D) a silane coupling agent containing a glycidyl group, wherein the amount of the component (D) is preferably 0.1 part to 10 parts by mass, relative to 100 parts by mass of the total amount of the component (A) and the component (B).

The curable resin composition of the sealing member for an organic EL element of the present invention is desirably a sheet curable resin composition shaped into a sheet in advance, and preferably having a viscosity of 20,000 Pa·s or more at 25°C and 5,000 Pa -s or below at 70°C in an uncured state. The composition shaped into a sheet can solve problems inherent in a liquid curable resin composition, such as low workability during a bonding process of a sealing member for an organic EL element to an organic EL element. Furthermore, the present invention relates to a sealing member for an organic EL element produced by bonding the sheet curable resin composition to the barrier film comprising the plastic film and the thin metal layer by a roll-to-roll process.

In addition, the present invention relates to an organic EL element for illumination devices sealed by the sealing member.

It is particularly preferred that in the case where the curable resin composition constituting the sealing member for an organic EL element is cured into a thickness of 20 $\mu$m, the cured product satisfies all the following conditions: generation of outgas in an amount of 2,000 $\mu$g/cm$^2$ or below when the product is placed at 120°C for 15 minutes, a shrinkage of 3% or below during curing, and a longitudinal thermal shrinkage (MD) of 1% or below and a transverse thermal shrinkage (TD) of 0.5% or below when the plastic film is heated at150°C for 30 minutes.

Advantageous Effects of the Invention

The sealing member for an organic EL element can be applied to organic EL elements used for many purposes, and particularly suitable for organic EL elements for illumination devices. Organic EL illumination, which has recently been studied, has a great potential for the use of illumination devices for the reasons that the elements have light emissive planes and can be formed into any shape using flexible substrates. As described above, organic EL elements for illumination devices require, for example, durability in various operational environments, applicability to any component, and productivity suitable for mass production. The sealing member for an organic EL element of the present invention can meet these requirements. That is, entirely sealed organic EL elements can prevent degradation of luminescence caused by formation and propagation of dark spots. Moreover, the organic EL elements sealed by the sealing member can provide an entire robust device structure, resulting in enhanced durability. The sealing member for an organic EL element, which is shaped into a flexible film, of the present invention is suitable for sealing flexible organic EL elements and can be readily produced by a roll-to-roll process, resulting in enhanced productivity.

Description of the Embodiments

The sealing member for organic EL elements of the present invention can provide an organic EL device that solves the above problems. The sealing member for organic EL elements is bonded by pressure to, for instance, an organic EL element including a transparent electrode, a hole-injecting and/or electron-injecting layer, a hole-transporting and/or electron-transporting layer, a light-emitting layer, and a rear electrode disposed on a flexible plastic film substrate to seal the organic EL element.

More specifically, the organic EL element sealed with the sealing member for organic EL elements of the present invention are fabricated as follows. A transparent electrode having a thickness of approximately 0.1 $\mu$m is deposited on a plastic film substrate. The transparent electrode is deposited, for example, through vacuum vapor deposition or sputter deposition. A hole-transporting layer and an organic EL layer each having a thickness of 0.05 $\mu$m are deposited on the transparent electrode in sequence. A rear electrode having a thickness of 0.1 to 0.3 $\mu$m is deposited on the organic EL layer to constitute an organic EL element. The vacuum vapor deposition may reduce surface smoothness due to crystal grains grown on the surface, resulting in destruction of an insulating layer or nonuniform luminescence in a thin-layer EL element. In contrast, the sputter deposition can provide a smooth surface suitable for stacking a thin-film device.

The sealing member for organic EL elements of the present invention is bonded on the rear electrode of the resulting organic EL element with, for example, a roll laminator or a vacuum laminator. In the present invention, a roll laminator is suitable for bonding the sealing member for organic EL elements from a perspective of productivity. The sealing member including the resin composition layer composed of a photocurable agent (c-1) is completely cured by exposure to active energy radiation such as ultraviolet rays. Afterbaking at 70 to 100°C is desirable to accelerate the curing. The sealing member including the resin composition layer composed of a thermosetting agent (c-2) is completely cured by heat. The sealing member including the resin composition layer composed of both the agents (c-1) and (c-2) is completely cured by exposure to active energy radiation followed by heating. In order to enhance the reliability of the organic EL element, the sealing member for organic EL elements can be bonded to an organic EL element provided with a protective inorganic film. Examples of the inorganic film include films of silicon oxide, silicon nitride, and silicon oxynitride. The sealing member including the resin composition layer composed of a photocurable agent (c-1) may be preliminarily exposed to ultraviolet rays to accelerate curing reaction, and may be bonded to an organic EL element during the curing reaction. In this case, the product may be afterbaked at 50 to 100°C for complete curing.

The plastic film for the sealing member for organic EL elements of the present invention has a thickness in the range of, preferably 1 to 50 $\mu$m, more preferably 10 to 30 $\mu$m, in order to minimize warpage of the film. A thickness under the lower limit cannot provide sufficiently reliable gas barrier properties, and a thickness exceeding the upper limit reduces flexibility after the film is laminated. Preferred material is at least one resin selected from the group consisting of polyethylene terephthalate (PET), polyvinyl alcohol (PVA), polyethylene naphthalate, polyamide, polyolefin, polycarbonate, polyether sulfone, and polyarylate resins. The most preferred is PET from a perspective of, for instance, gas barrier properties, economic efficiency, and adhesive properties of the curable resin composition. More preferably, the resin has a longitudinal thermal shrinkage (MD) of 1% or below and a transverse thermal shrinkage (TD) of 0.5% or below after being heated at 150°C for 30 minutes. The term "MD" refers to a shrinkage factor $S^{l6o}$ in the longitudinal or machine direction, and the term "TD" refers to a shrinkage factor $S^{l6o}$ in the transverse direction.

Preferably, the thin metal layer constituting the barrier film is composed of at least one metal selected from the group consisting of aluminum, magnesium, zinc, copper, gold, silver, platinum, tungsten, manganese, titanium, cobalt, nickel, and chromium. More preferred is aluminum having low incidence of pinhole defects. The thickness of the layers is preferably 1 to 50 $\mu$m, more preferably 20 to 40 $\mu$m. A thickness under the lower limit cannot provide sufficiently reliable gas barrier properties, and a thickness exceeding the upper limit may impairs flexibility to follow the substrates.

The curable resin composition layer disposed on the barrier film has nonfluidity at 25°C and gains fluidity at an elevated temperature in the range of 40 to 80°C. The term "nonfluidity" means that the value G' (storage elastic modulus) is greater than the value G" (loss elastic modulus) when the viscoelasticity is measured at 25°C. The term "to gain fluidity" refers to a phase that the values G' and G" are equal when the viscoelasticity is measured at an elevated temperature. The thickness of the curable resin composition layer is preferably in the range of 5 to 100 $\mu$m, more preferably 10 to 40 $\mu$m, which can follow the asperity of elements and fill in gaps, resulting in highly reliable adhesion. A thickness below the lower limit does not allow the composition to follow the asperity of elements. In contrast, a thickness above the upper limit precludes a homogeneous curing of coatings, which causes undesirable nonuniformity of the luminescence. For a cured resin composition having a thickness of 20 $\mu$m, it is particularly preferred that the cured product generates outgas in an amount of 2,000 $\mu$g/cm$^2$ or below when the product is placed at 120°C for 15 minutes, has a shrinkage of 3% or below during curing, and contains water in an amount of 1,500 ppm or below.

In the curable resin composition of the present invention, preferred examples of the compound (A) containing at least one glycidyl group per molecule and having a weight average molecular weight of 200 to 2,000 include epoxy resins, such as low-molecular-weight bisphenol A epoxy resins, low-molecular-weight bisphenol F epoxy resins, low-molecular-weight hydrogenated bisphenol A/F epoxy resins, and low-molecular-weight phenol novolac epoxy resins. Among these resins, more preferred are those having low chloride ion content, for instance, those containing hydrolytic chlorine of 500 ppm or below. The number of contained glycidyl groups is at least one, preferably 1 to 10, more preferably 1 to 5, and most preferably 1 to 3. Preferred examples of the component (A) include Epiclon EXA-835LV (trade mark, available from Dainippon Ink and Chemicals, Inc.) and jER152 (trade mark, available from Japan Epoxy Resins Co., Ltd.), which have low chloride ion content. The component (A) may contain a radical polymerizable compound having an unsaturated double bond in place of the glycidyl group. In such a case, a radical polymerization initiator can be added appropriately.

Preferred examples of the phenoxy resin (B) containing at least one glycidyl group per molecule and having a weight average molecular weight of 20,000 to 100,000 include bisphenol A phenoxy resins, bisphenol F phenoxy resins, and copolymers of bisphenol A and bisphenol F phenoxy resins. Among these resins, preferred are phenoxy resins that can produce a film with high hardness after the curable resin composition is shaped into a sheet. The number of glycidyl groups contained is at least one, preferably 1 to 10, more preferably 1 to 5, and most preferably 1 to 3. Preferred examples of the component (B) include jER1256 (trade mark, available from Japan Epoxy Resins Co., Ltd.) and YP-70 (trade mark, available from Tohto Kasei Co., Ltd.). The component (B) is added in an amount of, preferably 25 parts to 100 parts by mass, more preferably 30 parts to 70 parts by mass, relative to 100 parts by mass of the component (A). An amount below the lower limit precludes formation of a satisfactory film during sheeting. An amount above the upper limit leads to a stiff and brittle film after sheeting, which reduces workability during a bonding process. Furthermore, it causes the crosslink density to decrease and thus reduce the reliability of the product.

In the present invention, (C) (c-1) the compound generating an acid by exposure to active energy radiation is a salt that generates cationic active species by so-called light exposure. Examples of such a salt include aromatic onium salts such as aromatic diazonium, aromatic halonium, and aromatic sulphonium salts. Examples of the commercially available salts include SP-151, SP-170, SP-171, SP-150, and PP-33 (trade marks, available from Asahi Denka Co., Ltd.); Irgacure-261 and CG-24-61 (trade marks, available from Ciba-Geigy Ltd.); UVI-6974, UVI-6970, UVI-6990, and UVI-6950 (trade marks, available from Union Carbide Corporation); BBI-103, MPI-103, TPS-103, DTS-103, NAT-103, and NDS-103 (trade marks, available from Midori Kagaku Co., Ltd.); CI-2064, CI-2639, CI-2624, and CI-2481 (trade marks, available from Nippon Soda Co., Ltd.); RHODORSIL PHOTOINITIATOR 2074 (trade mark, available from Rhone-Poulenc S.A.); CD-1012 (trade mark, available from Sartomer Company Inc); FC-509 (trade mark, available from 3M Company); SI-60L, SI-80L, and SI-100L (trade marks, available from Sanshin Chemical Industry Co., Ltd.); IBPF, IBCF, TS-01, and TS-02 (trade marks, available from Sanwa Chemical Co., Ltd.); and UVE1014 (trade mark, available from General Electric Company).

The thermal latent curing agent (c-2) may be any known curing agent for a heat-cured epoxy resin. In the present invention, from perspectives of high compatibility with components (A) and (B), high stability, and low pigmentation, particularly preferred is a latent imidazole compound being solid at room temperature and having a melting point or decomposition temperature of 80°C or more. Examples of such a compound include 2-methylimidazole, 2-heptadecylimidazole, 2-phenylimidazole, 2-phenyl-4-methylimdazole, 1-cyanoethyl-2-phenylimidazole, 1-cyanoethyl-2-undecylimidazoliumtrimellitate, 1-cyanoethyl-2-phenylimidazoliumtrimellitate, 2,4-diamino-6-[2'-methylimidazolyl-(1')]-ethyl-S-triazine, 2,4-diamino-6-[2'-undecylimidazolyl-(1')]-ethyl-S-triazine, 2,4-diamino-6-[2'-ethyl-4'-methylimidazolyl-(1')]-ethyl-S-triazine, 2,4-diamino-6-[2'-methylimidazoly1-(1')]-ethyl-S-triazine-isocyanu ric acid adduct, 2-phenylimidazole-isocyanuric acid adduct, 2-methylimidazole-isocyanuric acid adduct, 2-phenyl-4,5-dihydroxymethylimidazole, 2-phenyl-4-methyl-5-hydroxymethylimidazole, 2-methylimidazoline, 2-phenylimidazoline, and 2,3-dihydro-1H-pyrrolo[1,2-a]benzimidazole.

The component (C) functions as a curing agent for the components (A) and (B). Regarding the amount of the component (C) to be added, in perspective of preservability, curability, and permeability, the component (c-1) is added in an amount of preferably 0.1 part to 5 parts by mass, more preferably 0.3 part to 3 parts by mass, relative to 100 parts by mass of the total amount of the components (A) and (B). The component (c-2) is added in an amount of preferably 0.1 part to 20 parts by mass, more preferably 0.5 part to 5 parts by mass. With the component (c-2), an amount below the lower limit cannot provide sufficient curing of the components (A) and (B), and an amount above the upper limit accelerates pigmentation and causes poor stability in the composition.

The silane coupling agent (D) containing a glycidyl group of the present invention can provide high adhesion to adherends without pigmentation of the composition. The silane coupling agent (D) containing a glycidyl group also has high compatibility with components (A) and (B), which results in no segregation in the composition or no exudation after the composition is shaped into a sheet. Examples of the component (D) of the present invention include silane coupling agents such as 3-glycidoxypropyltrimethoxysilane, 3-glycidoxypropylmethyldimethoxysilane, 3-glycidoxypropylmethyldimethoxysilane, and 2-(3,4-epoxycyclohexyl)ethyltrimethoxysilane. These silane coupling agents may be used in combination. Among them, particularly preferred is 3-glycidoxypropyltrimethoxysilane (KBM-403 (trade mark) available from Shin-Etsu Chemical Co., Ltd.), which has high compatibility with components (A) and (B) and exhibits high stability. The component (D) is added in an amount of preferably 0.1 part to 10 parts by mass, more preferably 0.3 part to 3 parts by mass, relative to 100 parts by mass of the total amount of the components (A) and (B). An amount below the lower limit is insufficient to provide adhesion, and an amount above the upper limit inevitably generates outgas, which may cause adverse effects on organic EL elements. The outgas reacts with dye molecules in the organic EL element to decrease the activity of the dye molecules, and deactivated portions appear as dark spots. Growing dark spots causes the luminescent area to decrease, resulting in finally a severe defect for illumination and display devices. The amount of outgas generated from the curable resin composition and causing such a problem is 2,000 $\mu$g/cm$^2$ or more in the sealing member.

The curable resin composition of the present invention is prepared by dissolving the components (A) to (D) in an organic solvent such as methyl ethyl ketone or toluene, the resulting solution is applied into a uniform thickness on the thin metal layer of a barrier film consisting of a thin metal layer and a plastic film using a coater for instance, and then, the organic solvent is evaporated to form a solid sheet (a film, a tape) of the sealing member at room temperature (approximately 25°C) for organic EL elements. In the present invention, the curable resin composition may be applied to a PET film in a similar manner in advance, to produce a sheet curable resin composition. In such a case, the sheet composition may be rolled up together with, for instance, release paper. The sheet curable resin composition of the present invention can be bonded to the barrier film by a roll-to-roll process into a uniform thickness of a film at high yield, without a coating process using a coater. Moreover, the curable resin composition can avoid trapping of air bubbles during the sheeting process, and thus can deliver both productivity and reliability.

The curable resin composition of the present invention gains fluidity at a temperature in the range of 40 to 80°C. Such a property enables the curable resin composition fluidized by heat to smoothly fill in recesses on the surface of an organic EL element and thus can avoid trapping of air bubbles after the element is sealed. At 40°C or below, such a curable resin composition exhibits excess flowability during a thermal printing process, which results in low workability and poor retention of the sheet shape. In contrast, a fluidizing temperature of 80°C or more causes low flowability during a thermal printing process, resulting in tendency of trapping air bubbles and excess heating that may cause adverse effects on the organic EL element. The term "solid state at 25°C" as described above, indicates a range that a curable resin composition having a viscosity of preferably 20,000 Pa·s or more, more preferably 150,000 Pa·s or below. The term "to have flowability at a temperature in the range of 40 to 80°C" indicates a range that a curable resin composition having a viscosity of preferably 5,000 Pa·s or below, more preferably 500 Pa·s or more at 70°C. A composition in a solid state at room temperature can be preserved for a long period at a low temperature, and preferably preserved with a desiccant such as silica gel to keep its moisture content within a specific range.

Any other component, for instance, storage stabilizers, plasticizers, and tack control agents can be added within the scope of the purpose of the present invention. However, the contents of moisture and impurities in the additives must be severely controlled.

The sealing member for organic EL elements of the present invention having such a configuration has a water vapor permeation rate of 0.1g/m$^2$×24 hours or below and a heat transfer rate of 0.5kW/h or more at an ambient temperature of 60°C and humidity of 95%.

Examples

The present invention is described further in detail below by way of examples. The present invention, however, should not be limited to these examples.

[Evaluation of Curable Resin Compositions]

Each of the curable resin compositions was prepared in accordance with formulation shown in Table 1 and subjected to evaluation tests. The components used herein are as follows. The amount of each component is represented by weight unless otherwise indicated.

Components (A) and Comparative component

Epiclon EXA-835LV (trade mark): a mixture of bisphenol A and F epoxy resin containing two glycidyl groups per molecule (low chloride content, a mixture of epoxy resins each having a weight average molecular weight in the range of 300 to 350), available from Dainippon Ink and Chemicals, Inc.) (abbreviated as "EXA835LV" in Table 1).
jER152 (trade mark): phenol novolac epoxy resin containing two glycidyl groups per molecule (weight average molecular weight: approximately 530, available from Japan Epoxy Resins Co., Ltd.).
jER1001 (trade mark): solid bisphenol epoxy resin containing two glycidyl groups per molecule (weight average molecular weight: approximately 900, available from Japan Epoxy Resins Co., Ltd.).
jER1010 (trade mark) (comparative component): solid bisphenol epoxy resin containing two glycidyl groups per molecule (weight average molecular weight: approximately 5,500, available from Japan Epoxy Resins Co., Ltd.).

Components (B) and Comparative component

YP-70 (trade mark): phenoxy resin containing two glycidyl groups per molecule (weight average molecular weight: approximately 50,000, available from Tohto Kasei Co., Ltd.).
jER1256 (trade mark): phenoxy resin containing two glycidyl groups per molecule (weight average molecular weight: approximately 50,000, available from Japan Epoxy Resins Co., Ltd.).
Epofriend CT310 (trade mark) (comparative component): copolymer of styrene and butadiene containing a glycidyl group (weight average molecular weight: approximately 50,000 to 150,000, available from Daicel Chemical Industries Co., Ltd.) (abbreviated as "CT310" in Table 1).

Components (C)

(c-1) ADEKA OPTOMER SP-170 (trade mark) : 4,4-bis{di(β-hydroxyethoxy)phenylsulfonyl}phenyl sulfide-bis-hexafluoroantimonate (available from Asahi Denka Co., Ltd.) (abbreviated as "SP-170" in Table 1).
(c-2) 2PZ-CNS-PW (trade mark):
1-cyanoethyl-2-phenylimidazoliumtrimellitate (available from Shikoku Chemicals Corporation).

Component (D)

KBM403 (trade mark): 3-glycidoxypropyltrimethoxysilane (available from Shin-Etsu Chemical Co., Ltd.).
Various evaluation tests (for evaluating various characteristics) shown in Table 1 were performed as follows.

Measurement of viscosity (uncured state)

The curable resin compositions of Compounding Examples 1 to 5 and Comparative Compounding Examples 1 to 5 were prepared in accordance with the formulations shown in Table 1, as follows: The component (C) was added to the component (A) with stirring at room temperature into a homogeneous solution [solution (X)] . The component (B) was added to methyl ethyl ketone solvent with stirring at room temperature into a homogeneous solution [solution (Y)]. These solutions (X) and (Y) and the component (D) were mixed with stirring at room temperature into a curable resin composition.

Each curable resin composition was applied onto a polyethylene terephthalate (PET) film pretreated with a parting agent and shaped into a film using a coater, which was then heated at 80°C for three minutes to remove the solvent. The resulting film was cut along with the PET film into a size of 200 mm long by 250 mm wide, and then shaped into a film having a thickness of 20 $\mu$m by removing the PET film. The resulting film was folded alternatively in the vertical and horizontal directions six times in total into a thickness of 1.0 mm or more. A stainless steel spacer having a thickness of 1.0 mm was placed on the entire periphery of the folded sample, and the sample was compressed and deaerated under reduced pressure using a vacuum laminator to form a test piece having a thickness of 1.0 mm for viscosity measurement.

The viscosity was measured with a rheometer DAR-100 (trade mark) available from Reologica Instruments AB at 25°C and 70°C.

Measurement of flow temperature

A film having a thickness of 20 $\mu$m was prepared as in the above viscosity measurement, which was folded into five layers having a thickness of 100 $\mu$m, and then was deaerated using a vacuum laminator to obtain a test piece. The flow temperature was measured by a rheometer DAR-100 available from Reologica Instruments AB at a heating rate of 4°C/min in the range of 10 to 150°C. The term "flow temperature" refers to a temperature at which values G' (storage elastic modulus) and G" (loss elastic modulus) are equal in the measurement with the rheometer.

Measurement of amount of outgas

A film having a thickness of 20 $\mu$m was prepared as in the above viscosity measurement, approximately 5 mg of which was weighed out so as to retain its thin-film shape to obtain a test piece. The amount of outgas generated by heating the test piece at 120°C for 15 minutes (unit: $\mu$g/cm$^2$) was measured by a dynamic space method that combines a double-shot pyrolyzer [PY2020iD (trade mark) available from Frontier Laboratories Ltd.] and a gas chromatograph/ mass spectrometer (GC-MS) [6890N/5973inert (trade mark) available from Agilent Technologies]. The total amount of outgas was determined using n-decane as a standard substance. The term "amount of outgas ($\mu$g/cm$^2$)" refers to the weight of outgas that generated per unit area of the surface of test piece, which was calculated as follows. The weight of outgas generated from approximately 5 mg of the test piece was measured as in the above manner, and was then converted into the weight of outgas generated from 1 g of the test piece ($\mu$g/g). A test piece of 1 cm by 1 cm was cut out from the film having a thickness of 20 $\mu$m. The weight of the test piece per cm$^2$ (g/cm$^2$) was measured. These values were multiplied, namely, the amount of outgas ($\mu$g/cm$^2$) was obtained by [weight of generated outgas ($\mu$g/g)] $\times$ [weight of test piece per cm$^2$ (g/cm$^2$)].

Measurement of curing shrinkage

A film having a thickness of 1.0 mm was prepared as in the above viscosity measurement, and was then cut out into a test piece of 2.0 mm long by 2.0 mm wide for measuring curing shrinkage. The test piece was weighed in the atmosphere and distilled water. These weighed values were referred to as W1 or W2, respectively. Test pieces prepared from Compounding Examples 1 to 4 and Comparative Compounding Examples 1 to 5 that used (c-2) a thermal latent curing agent as the component (C), were cured by heating at 100°C for three hours. A test piece prepared from Compounding Example 5 that used (c-1) a compound generating photoacid as the component (C) was exposed to ultraviolet rays of 6,000 mJ/cm$^2$ and then cured at 80°C for one hour in a heater. Each test piece cured in this manner was again weighed in the atmosphere and distilled water. The weighed values were referred to as W3 or W4, respectively. All the weights were determined at an accuracy of 1 mg. The curing shrinkage ($\Delta$V) was calculated with the following formula:

$$\Delta V\ (\%) = [(W3\text{-}W4) \text{-} (W1\text{-}W2)] \times 100/(W1\text{-}W2).$$

The results are shown in Table 1 below.

[Table 1]

Table 1

| Component | | Compounding Example | | | | | Comparative Compounding Example | | | | |
|---|---|---|---|---|---|---|---|---|---|---|---|
| | | 1 | 2 | 3 | 4 | 5 | 1 | 2 | 3 | 4 | 5 |
| (A) | EXA835LV | 25 | - | 25 | 25 | 25 | - | 25 | 45 | 25 | 25 |
| | jER152 | - | - | - | - | - | - | - | 45 | 25 | 25 |
| | jER1001 | 25 | 50 | 25 | 25 | 25 | - | 25 | - | - | - |
| Comparative (A) | jER1010 0 | - | - | - | - | - | 50 | - | - | - | - |
| (B) | YP-70 | 30 | 50 | 50 | - | 50 | 50 | - | 20 | 100 | 50 |
| | jER1256 | - | - | - | 25 | - | - | - | - | - | - |
| Comparative (B) | CT310 | - | - | - | - | - | - | 50 | - | - | - |
| (C) | | | | | | | | | | | |
| (c-1) | SP-170 | - | - | - | - | 1.5 | - | - | - | - | - |
| (c-2) | 2PZ-CNS-PW | 5 | 5 | 5 | 5 | - | 5 | 5 | 5 | 5 | 5 |
| (D) | KBM403 | 1 | 1 | 1 | 1 | 1 | 1 | 1 | 1 | 1 | 15 |
| Organic solvent | Methyl ethyl ketone | 200 | 200 | 200. | 200 | 200 | 200 | 200 | 200 | 200 | 200 |
| Characteristics | | | | | | | | | | | |
| Uncured viscosity (25°C) | Pa·s | 56,000 | 120,000 | 78,000 | 25,000 | 86,000 | 240,000 | 98,000 | 18,000 | 350,000 | 16,500 |
| (70°C) | Pa·s | 1,950 | 3,260 | 2,530 | 1,080 | 2,300 | 6,330 | 6,310 | 760 | 7,680 | 950 |
| Flow temperature | °C | 60 | 75 | 65 | 45 | 62 | 80 | 68 | 38 | 95 | 45 |
| Amount ofoutgas (120°C) | $\mu$g/cm$^2$ | 750 | 190 | 240 | 550 | 1,620 | 430 | 320 | 330 | 510 | 2,840 |
| Curing shrinkage | % | 2.3 | 1.9 | 1.8 | 2.2 | 2.0 | 1.7 | 2.3 | 3.1 | 2.1 | 3.5 |

## EP 2 475 223 A1

(Examples 1 to 8 and Comparative Examples 1 to 7)

As shown in Tables 2 and 3, curable resin compositions of Compounding Examples 1 and 5 and Comparative Compounding Examples 1 to 5 in Table 1 were used in Examples and Comparative Examples. Each curable resin composition was applied onto a polyethylene terephthalate (PET) film pretreated with a parting agent and shaped into a sheet having a thickness ($\mu$m) shown in Tables 2 and 3 using a coater.

A thin metal layer having a thickness $\mu$m) shown in Tables 2 and 3was deposited on a plastic film having a thickness ($\mu$m) shown in Tables 2 and 3 to form a barrier film. The resulting sheet curable composition was then bonded to the thin metal layer of the barrier film by a roll-to-roll process using a roll laminator (Dry Film Laminator available from MCK Co., Ltd.) and formed into a sealing member for organic EL elements by removing the PET film. In Example 7, thin aluminum for the barrier film was deposited.

A transparent electrode was deposited by sputtering on a PET film into a layer having a thickness of 0.1 $\mu$m, a hole-transporting layer and an organic EL layer each having a thickness of 0.05 $\mu$m were deposited in sequence on the electrode, and a rear electrode having a thickness of 0.2 $\mu$m was deposited on the organic EL layer to complete an organic EL element for evaluation.

The sheet curable composition of the sealing member for organic EL elements was disposed so as to face the rear electrode of the organic EL element. The sealing member was then bonded to the organic EL element with a roll laminator, which was followed by heating with a vacuum laminator. In order to seal the organic EL element, the sheet curable composition thermally bonded to the organic EL element was exposed to ultraviolet rays of 6,000 mJ/cm$^2$ and then cured at 80°C for one hour in a heater in Example 5, while each sheet curable composition was cured at 100°C for three hours in other Examples and Comparative Examples.

These sealing members for organic EL elements and sealed organic EL element were subjected to tests for evaluating the following characteristics.

Permeability

The permeability of the sealing member for organic EL elements was measured using a water vapor permeation analyzer (L80-5000 (trade mark) available from Lyssy AG) at 60°C and 95% Rh. The water vapor permeation analyzer has a detection limit of 0.1 g/m$^2$ ·day.

Warpage of substrate

The warpage of a substrate of the sealing member for organic EL elements, which indicates the toughness of the substrate required for the use in illumination devices, was evaluated as follows. The sheet curable composition of the sealing member for organic EL elements was disposed so as to face a surface of alkali glass of 0.7 mm thick by 300 mm long by 350 mm wide. The sealing member was then bonded to the alkali glass with a roll laminator at 80°C, a pressure of 0.1 MPa, and a rolling speed of 0.3 m/min. To complete the bonding to the alkali glass, the sealing member for organic EL elements was exposed to ultraviolet rays of 6,000 mJ/cm$^2$ and then cured at 80°C for one hour in a heater in Example 5, while each sheet curable composition was cured at 100°C for three hours in other Examples and Comparative Examples. The alkali glass was then placed on a horizontal plane to determine the displacements of edges of the sealing member after the bonding. The values of the displacement at all edges were evaluated as "G" for 1.0 mm or below; "M" for the range of 1 mm$\pm$0.2 mm; or "B" for above 1.0 mm. The samples indicated by "G" or "M" are acceptable while ones indicated by "B" are rejected.

Productivity

The productivity required for fabrication of illumination devices from the sealing member for organic EL elements was evaluated. For evaluation of the productivity, the sheet curable composition of the sealing member for organic EL elements was disposed so as to face a PET film having a thickness of 125 $\mu$m, the sealing member was then bonded to the PET film using a roll laminator at 80°C, a pressure of 0.1 MPa, and a rolling speed of 0.3 m/min, and the adherend interface was observed. Air bubbling, surface penetration of the resin, or interfacial separation was: not observed, which was indicated with "G"; slightly observed, which was indicated with "M"; and observed, which was indicated with "B". The samples indicated with "G" and "M" are acceptable while ones indicated with "B" are rejected.

Nonuniformity of luminance

The uniformity of the sealing of the sealed organic EL element was evaluated by the nonuniformity of the luminance, which was evaluated by the temperature distribution of the light emitting surface using an infrared thermograph [FVS-7000E (trade mark) available from Apiste Corporation]. The maximum difference of the temperature in the surface after 5V was applied to the sealed organic EL element was evaluated by the following criterion: with "G" for 15°C or below; "M" for above 15°C to 30°C; and "B" for above 30°C. The samples indicated with "G" or "M" are acceptable while ones indicated with "B" are rejected.

Degradation of luminescence

The changes in the luminescence characteristics, which indicate the reliability of the sealing member, was evaluated by the difference of the drive voltage after the sealed organic EL element was allowed stand for 500 hours at an ambient temperature of 85°C and humidity of 85%. The rate of change of the drive voltage after a current of 0.1 mA was applied to the sealed organic EL element was evaluated by the following criterion: "G" for 10% or below; "M" for above 10% to 20%; and "B" for above 20%. The samples indicated with "G" and "M" are acceptable while ones indicated with "B" are rejected.

The results are shown in Tables 2 and 3.

Table 2

| | | Example | | | | | | | |
|---|---|---|---|---|---|---|---|---|---|
| | | 1 | 2 | 3 | 4 | 5 | 6 | 7 | 8 |
| Curable resin compositions | | Compounding Example 1 | Compounding Example 1 | Compounding Example 1 | Compounding Example 1 | Compounding Example 5 | Compounding Example 1 | Compounding Example 1 | Compounding Example 1 |
| Thickness of sheet curable | composition μm) | 20 | 20 | 20 | 50 | 20 | 20 | 20 | 20 |
| Thickness of thin metal layer (μm) | Thin A1 | 30 | - | 30 | 30 | 30 | 80 | - | 30 |
| | Al, vapor dep. | - | - | - | - | - | - | 0.6 | - |
| | Thin Cu | - | 30 | - | - | - | - | - | - |
| Thickness of plastic film (μm) | PET | 25 | 25 | | 25 | 25 | 25 | 25 | 80 |
| | PVA | | | 25 | | | | | |
| Characteristics | | | | | | | | | |
| Permeability (60°C, 95%Rh) | (g/m2·day) | < 0.1 | < 0.1 | < 0.1 | < 0.1 | < 0.1 | < 0.1 | 0.5 | < 0.1 |
| Degradation of luminance | | G | G | G | G | G-M | G | M | G |
| Nonuniformity of luminance | | G | G | G | G | G | G | M | G |
| Warpage of substrate | | G | G | G-M | G | G | G-M | G | M |
| Productivity | | G | G | G | G-M | G | M | G | G-M |

Table 3

| | | Comparative Example | | | | | | |
|---|---|---|---|---|---|---|---|---|
| | | 1 | 2 | 3 | 4 | 5 *1 | 6 *2 | 7 |
| Curable resin compositions | | Compounding Example 1 | Compounding Example 1 | Comparative Compounding Example 1 | Comparative Compounding Example 2 | Comparative Compounding Example 3 | Comparative Compounding Example 4 | Comparative Compounding Example 5 |
| Thickness of sheet curable composition ($\mu$m) | | 120 | 2.0 | 2.0 | 20 | 20 | 20 | 20 |
| Thickness of thin metal layer ($\mu$m) | Thin Al | 30 | 30 | 30 | 30 0 | 30 | 30 | 30 |
| | Al, vapor dep. | - | - | | | | | |
| | Thin Cu | - | - | - | - | - | - | - |
| Thickness of plastic film ($\mu$m) | PET | 25 | 25 | 25 | 25 5 | 25 | 25 | 25 |
| | PVA | | | | | | | |
| Characteristics | | | | | | | | |
| Permeability (60°C, 95%Rh) (g/m2•day) | | < 0.1 | <0.1 | < 0.1 | < 0.1 | < 0.1 | < 0.1 | < 0.1 |
| Degradation of luminance Nonuniformity of luminance Warpage of substrate Productivity | | M G B B | M B B M | B M G G | B B G M | G G G G | G G G G | B M B G |
| "*1": the characteristics of the sealed organic EL element were satisfactory, but during the alignment in the bonding step of the sealing member for organic EL elements to the organic EL element, the curable composition of the sealing member partially stuck to the organic EL element, resulting in inevitable chipping of the surface of the sealing member for organic EL elements. "*2": the characteristics of the sealed organic EL element were satisfactory, but a relatively high temperature was required during the bonding of the organic EL element, resulting damaging the organic EL element. | | | | | | | | |

The curable resin composition of the Compounding Example 1 was used in Examples 1 to 4 and 6 to 8. In Examples 1 and 2, the thin metal layers were composed of thin aluminum and thin copper, respectively. Excellent results were achieved with either metal. In Example 3, the plastic film was composed of polyvinyl alcohol (PVA), resulting in slight warpage of the substrate relative to the polyethylene terephthalate (PET) film in Example 1, which however did not impair the advantages of the present invention. In Example 4, the sheet curable composition had a large thickness, resulting in slightly lower productivity. In Example 6, the thin metal layer had a large thickness, resulting in slight warpage of the substrate and slightly lower productivity, which however did not impair the advantages of the present invention. In Example 7, aluminum for the thin metal layer was deposited on the plastic film, resulting in slightly higher permeability, slightly lower luminescence, and slightly higher nonuniformity of the luminance, any of which however did not impair the advantages of the present invention. In Example 8, the PET film had a large thickness, resulting in just slightly warpage of the substrate. Example 5 composed of the curable resin composition of Compounding Example 5 had excellent results similar to Example 1.

In Comparative Example 1, the sheet curable composition had a significantly larger thickness compared to the composition in Example 1, resulting in significant warpage of the substrate and lower productivity. In Comparative Example 2, the sheet curable composition had a relatively smaller thickness in contrast to Comparative Example 1, resulting in a noticeable warpage of the substrate and significant nonuniformity of the luminance. Comparative Example 3 composed of the curable resin composition of Comparative Compounding Example 1 had significantly low luminescence. Comparative Example 4 composed of the curable resin composition of Comparative Compounding Example 2 had significantly low luminescence and significantly high nonuniformity of the luminance. Comparative Example 5 composed of the curable resin composition of Comparative Compounding Example 3 provides satisfactory characteristics of the sealed organic EL element. The composition however exhibited significantly high surface tackiness for the use in a sealing member for organic EL elements due to its low viscosity at 25°C in an uncured state. The composition partially stuck to the organic EL element during the alignment in the bonding step of the sealing member to the organic EL element, resulting in inevitable chipping in the surface of the sealing member for organic EL elements. Comparative Example 6 composed of the curable resin composition used of Comparative Compounding Example 4 had satisfactory characteristics of the sealed organic EL element. The curable resin composition, however, had a high flow temperature of above 80°C and thus requires a relatively high temperature for adhesion to the organic EL element, resulting in damaging the organic EL element. Comparative Example 7 composed of the curable resin composition of Comparative Compounding Example 5 had dark spots which were observed in the early stage after the sealed organic EL element was allowed stand under a predetermined atmosphere for evaluating any degradation of the luminescence, which were seemed to result from a significant amount of outgas generated from the curable resin composition. Moreover, the composition of the Comparative Compounding Example 5 had a high curing shrinkage, resulting in a significant warpage of the substrate causing interfacial separation between the organic EL element and the sealing member, which led to low reliability of the adhesion.

Industrial Applicability

The sealing member for organic EL elements of the present invention is preferably used in sealing organic EL elements, in particular, organic EL elements for illumination.

**Claims**

1. A sealing member for an organic EL element comprising:

   a barrier film comprising a plastic film and at least one thin metal layer; and
   a curable resin composition layer on the barrier film,

   wherein the curable resin composition layer has a thickness of 5 to 100 $\mu$m and the curable resin composition has nonfluidity at 25°C in an uncured state and gains fluidity at an elevated temperature in the range of 40 to 80°C.

2. The sealing member for an organic EL element according to claim 1, wherein the thin metal layer comprises at least one metal selected from the group consisting of aluminum, magnesium, zinc, copper, gold, silver, platinum, tungsten, manganese, titanium, cobalt, nickel, and chromium and has a thickness of 1 to 50 $\mu$m; and the plastic film comprises at least one resin selected from the group consisting of polyethylene terephthalate, polyvinyl alcohol, polyethylene naphthalate, polyamide, polyolefin, polycarbonate, polyether sulfone, and polyarylate and has a thickness of 1 to 50 $\mu$m.

**3.** The sealing member for an organic EL element according to claim 1 or 2, wherein the thin metal layer comprises aluminum and the plastic film comprises polyethylene terephthalate.

**4.** The sealing member for an organic EL element according to any one of claims 1 to 3, wherein the curable resin composition layer comprises:

(A) a compound containing at least one glycidyl group per molecule and having a weight average molecular weight of 200 to 2,000;
(B) a phenoxy resin containing at least one glycidyl group per molecule and having a weight average molecular weight of 20,000 to 100,000;
(C) (c-1) a compound generating an acid by exposure to active energy radiation, and/or (c-2) a thermal latent curing agent; and
(D) a silane coupling agent containing a glycidyl group.

**5.** The sealing member for an organic EL element according to claim 4, wherein the amount of the component (B) is 25 parts to 100 parts by mass relative to 100 parts by mass of the component (A); the amount of the component (c-1) is 0.1 part to 5.0 parts by mass and/or the amount of the component (c-2) is 0.1 part to 20 parts by mass, relative to 100 parts by mass of the total amount of the component (A) and the component (B); the amount of the component (D) is 0.1 part to 10 parts by mass, relative to 100 parts by mass of the total amount of the component (A) and the component (B).

**6.** The sealing member for an organic EL element according to any one of claims 1 to 5, wherein the curable resin composition is shaped into a sheet in advance and has a viscosity of 20,000 Pa·s or more at 25°C and 5,000 Pa·s or below at 70°C in an uncured state.

**7.** The sealing member for an organic EL element according to claim 6, wherein the sheet curable resin composition is bonded to the barrier film by a roll-to-roll process.

**8.** The sealing member for an organic EL element according to any one of claims 1 to 7, sealing an organic EL element for an illumination device or an image display device.

**9.** The sealing member for an organic EL element according to any one of claims 1 to 8, wherein the sealing member for an organic EL element is cured into a thickness of 20 $\mu$m; the cured product generates outgas in an amount of 2,000 $\mu$g/cm$^2$ or below when placed at 120°C for 15 minutes; and has a curing shrinkage of 3% or below.

<table>
<tr><td colspan="2" align="center">**INTERNATIONAL SEARCH REPORT**</td><td colspan="2">International application No.<br>PCT/JP2010/065010</td></tr>
<tr><td colspan="4">A.   CLASSIFICATION OF SUBJECT MATTER<br>*H05B33/04*(2006.01)i,  *B32B15/08*(2006.01)i,  *B32B15/092*(2006.01)i,  *C08G59/68*<br>(2006.01)i,  *H01L51/50*(2006.01)i<br><br>According to International Patent Classification (IPC) or to both national classification and IPC</td></tr>
<tr><td colspan="4">B.   FIELDS SEARCHED</td></tr>
<tr><td colspan="4">Minimum documentation searched (classification system followed by classification symbols)<br>H05B33/04, B32B15/08, B32B15/092, C08G59/68, H01L51/50</td></tr>
<tr><td colspan="4">Documentation searched other than minimum documentation to the extent that such documents are included in the fields searched<br>    Jitsuyo Shinan Koho       1922-1996   Jitsuyo Shinan Toroku Koho   1996-2010<br>    Kokai Jitsuyo Shinan Koho   1971-2010   Toroku Jitsuyo Shinan Koho   1994-2010</td></tr>
<tr><td colspan="4">Electronic data base consulted during the international search (name of data base and, where practicable, search terms used)</td></tr>
</table>

C.   DOCUMENTS CONSIDERED TO BE RELEVANT

| Category* | Citation of document, with indication, where appropriate, of the relevant passages | Relevant to claim No. |
|---|---|---|
| Y | WO 2006/104078 A1  (Three Bond Co., Ltd.),<br>05 October 2006 (05.10.2006),<br>paragraphs [0005], [0011] to [0013], [0018] to<br>[0026]; fig. 2<br>(Family: none) | 1-9 |
| Y | WO 2007/123006 A1  (Konica Minolta Holdings,<br>Inc.),<br>01 November 2007 (01.11.2007),<br>paragraphs [0200], [0201]<br>& US 2009/0167164 A1    & EP 2011639 A1 | 1-9 |
| Y | JP 2001-237065 A  (Toppan Printing Co., Ltd.),<br>13 August 2001 (13.08.2001),<br>paragraphs [0023], [0031]<br>(Family: none) | 1-9 |

| ☒   Further documents are listed in the continuation of Box C. | ☐   See patent family annex. |
|---|---|

| *   Special categories of cited documents:<br>"A"  document defining the general state of the art which is not considered<br>    to be of particular relevance<br>"E"  earlier application or patent but published on or after the international<br>    filing date<br>"L"  document which may throw doubts on priority claim(s) or which is<br>    cited to establish the publication date of another citation or other<br>    special reason (as specified)<br>"O"  document referring to an oral disclosure, use, exhibition or other means<br>"P"  document published prior to the international filing date but later than<br>    the priority date claimed | "T"  later document published after the international filing date or priority<br>    date and not in conflict with the application but cited to understand<br>    the principle or theory underlying the invention<br>"X"  document of particular relevance; the claimed invention cannot be<br>    considered novel or cannot be considered to involve an inventive<br>    step when the document is taken alone<br>"Y"  document of particular relevance; the claimed invention cannot be<br>    considered to involve an inventive step when the document is<br>    combined with one or more other such documents, such combination<br>    being obvious to a person skilled in the art<br>"&"  document member of the same patent family |
|---|---|
| Date of the actual completion of the international search<br>    28 September, 2010 (28.09.10) | Date of mailing of the international search report<br>    12 October, 2010 (12.10.10) |
| Name and mailing address of the ISA/<br>    Japanese Patent Office | Authorized officer |
| Facsimile No. | Telephone No. |

## INTERNATIONAL SEARCH REPORT

| | International application No. |
| --- | --- |
| | PCT/JP2010/065010 |

C (Continuation).    DOCUMENTS CONSIDERED TO BE RELEVANT

| Category* | Citation of document, with indication, where appropriate, of the relevant passages | Relevant to claim No. |
| --- | --- | --- |
| Y | JP 2003-51386 A (Toppan Printing Co., Ltd.), 21 February 2003 (21.02.2003), paragraph [0030] (Family: none) | 3 |
| Y | JP 2007-200692 A (Konica Minolta Holdings, Inc.), 09 August 2007 (09.08.2007), paragraphs [0009], [0053] (Family: none) | 9 |

## REFERENCES CITED IN THE DESCRIPTION

**Patent documents cited in the description**

- JP H337991 B
- JP H3261091 B
- JP H4212284 B
- JP H536475 B
- JP H4363890 B
- JP H589959 B
- JP H5129080 B
- JP 2001237065 A
- JP 2007109422 A
- JP 2007284475 A
- JP 2001237064 A
- JP H11274377 B
- JP H9176413 B

- JP H9235357 B
- JP H10135255 B
- JP 2004059718 A
- JP 2004210901 A
- JP 2004115650 A
- JP 2004292594 A
- JP 2008059945 A
- WO 2005019299 A
- JP 2005129520 A
- JP 2005216856 A
- JP 2004234868 A
- JP 2004047381 A
- WO 2006104078 A